# EUROPÄISCHE PATENTSCHRIFT

(11) **EP 1 929 554 B1**
(45) Veröffentlichungstag und Bekanntmachung des Hinweises auf die Patenterteilung: **11.03.2009**
(21) Anmeldenummer: 06793311.9
(22) Anmeldetag: 07.09.2006
(51) Int. Cl.: H01L 41/04, F02M 51/06, F02M 51/00, H01L 41/083

(54) **ANORDNUNG MIT EINEM PIEZOAKTOR UND EIN VERFAHREN ZU DESSEN HERSTELLUNG**
ARRANGEMENT COMPRISING A PIEZOACTUATOR AND METHOD FOR THE PRODUCTION THEREOF
ENSEMBLE COMPORTANT UN ACTIONNEUR PIEZOELECTRIQUE ET PROCEDE DE FABRICATION DUDIT ENSEMBLE

(30) Priorität: 22.09.2005 DE 102005045230
(43) Veröffentlichungstag der Anmeldung: 11.06.2008
(73) Patentinhaber: ROBERT BOSCH GMBH, 70442 Stuttgart (DE)
(72) Erfinder: HEINZ, Rudolf, 71272 Renningen (DE); KIENZLER, Dieter, 71229 Leonberg (DE); SCHAICH, Udo, 70378 Stuttgart (DE)
(86) Internationale Anmeldenummer: PCT/EP2006/066113
(87) Internationale Veröffentlichungsnummer: WO 2007/033910

(56) Entgegenhaltungen:
- WO-A-20/05073547
- DE-A1- 4 213 552
- DE-A1- 10 335 019
- DE-A1-4102004 015 57

## Beschreibung

### Technisches Gebiet

Die Erfindung betrifft eine Anordnung mit einem Piezoaktor, beispielsweise als Piezoinjektor zur Betätigung eines mechanischen Bauteils wie ein Ventil oder dergleichen, und ein Verfahren zu dessen Herstellung nach den gattungsgemäßen Merkmalen des Hauptanspruchs.

### Stand der Technik

Ein solche Anordnung ist beispielsweise vorteilhaft zur Steuerung des Hubs einer Nadel für die Kraftstoffeinspritzung in einem Kraftfahrzeug einsetzbar und zwar sowohl mit einer einstufigen als auch mit einer zweistufigen Übersetzung. Es ist an sich bekannt, dass zum Aufbau des zuvor erwähnten Piezoaktors ein Piezoelement so eingesetzt werden kann, dass unter Ausnutzung des sogenannten Piezoeffekts eine Steuerung des Nadelhubes eines Ventils oder dergleichen vorgenommen werden kann. Das Piezoelement ist aus einem Material mit einer geeigneten Kristallstruktur so aufgebaut, dass bei Anlage einer äußeren elektrischen Spannung eine mechanische Reaktion des Piezoelements erfolgt, die in Abhängigkeit von der Kristallstruktur und der Anlagebereiche der elektrischen Spannung einen Druck oder Zug in eine vorgebbare Richtung darstellt. Derartige Piezoaktoren eignen sich beispielsweise für Anwendungen, bei denen Hubbewegungen unter hohen Betätigungskräften und hohen Taktfrequenzen ablaufen.

Beispielsweise ist ein solcher Piezoaktor aus der DE 100 26 005 A1 bekannt, der zur Ansteuerung der Düsennadel bei Injektoren zur Einspritzung von Kraftstoff in den Brennraum eines Verbrennungsmotors verwendet werden kann. Bei diesem Piezoaktor ist ein Piezoelement, wie erwähnt, als Stapel mehrerer elektrisch miteinander gekoppelter piezokeramischen Schichten aufgebaut, der unter Vorspannung zwischen zwei Anschlägen gehalten ist. Jede piezokeramische Schicht ist als Piezolage zwischen zwei Innenelektroden eingefasst über die von außen eine elektrische Spannung angelegt werden kann. Aufgrund dieser elektrischen Spannung führen die piezokeramischen Schichten dann jeweils kleine Hubbewegungen in Richtung des Potentialgefälles aus, die sich zum Gesamthub des Piezoaktors addieren. Dieser Gesamthub ist über die Höhe der angelegten Spannung veränderbar und kann auf ein mechanisches Stellglied übertragen werden.

Bei dem zuvor erwähnten Piezoaktor wird zur Heranführung der unterschiedlichen Potentiale eine wechselseitige seitliche Kontaktierung der Innenelektroden über äußere Elektroden vorgenommen, bei der leitende Flächen auf jeweils einer Seitenfläche des Piezoelements angebracht sind, die mit den jeweiligen Innenelektroden kontaktiert sind. Dagegen ist aus der DE 103 35 019 A1 ein Piezoaktor bekannt, bei dem die Kontaktierung der Innenelektroden mit Kontaktelementen erfolgt, die jeweils in einer inneren Ausnehmung des Piezoelementes liegen.

Außerdem ist auch in der EP 1 174 615 A3 ein Piezoaktor beschrieben, bei dem ein Piezoelement als Aktor für die direkte Nadelhubsteuerung eines Einspritzinjektors für einen Verbrennungsmotor vorhanden ist. Zwischen dem Piezoelement als Aktor und der Nadel sitzt lediglich ein Koppler mit einer hydraulischen Übersetzung zum Dehnungsausgleich. Mit einer Aktivierung des Piezoelements wird hierbei die unter Vorspannung zum Verschluss der Einspritzdüse gehaltene Nadel von der Düsenöffnung wegbewegt, da die Nadel direkt übersetzt der Bewegung des Aktors folgt.

Beim eingangs erwähnten Stand der Technik DE 100 26 005 A1 wird der elektrische Anschluss des Piezoelements an eine externe Spannungsquelle durch eine Verlängerung der äußeren Elektroden durch ein Fußteil des Piezoaktors hindurch vorgenommen. Diese Verlängerung kann auch weiter bis zu einem Stecker geführt werden, so dass diese somit in einem mechanisch unkritischen Bereich kontaktiert werden. Die Verlängerungen können dabei elektrisch isoliert durch den Aktorfuß, z.B. aus Stahl, geführt werden, an dem das Piezoelement anliegt oder befestigt ist. Weiterhin ist es aus diesem Stand der Technik bekannt, dass die Verlängerungen zur Fixierung und zur Zugentlastung der Außenelektroden in einer Vergussmasse gehalten sind, welche in eine Ausnehmung des Aktorfußes, ggf. von einem Formteil aus Stahl oder Polymer umgeben, eingebracht sind.

Bei den zuvor beschriebenen Piezoaktoren ist zu beachten, dass die elektrischen Anbindungen im Herstellungsprozess einfach aber im Betrieb sicher erfolgen sollen, wobei zusätzlich zur elektrischen Isolierung auch bei vielen Anwendungen mit einer Ventilfunktion eine ausreichende Abdichtung gegenüber Flüssigkeiten, in der Regel über eine Glaseinschmelzung, gewährleistet sein muss. Insbesondere bei einer Anwendung der Piezoaktoren als Einspritzinjektoren für Kraftstoff in sogenannten Common-Rail-Systemen (CR) ist bei den verwendeten hohen Drücken des Kraftstoffs eine sichere Bauweise erforderlich.

Eine eventuell vorhandene Steckverbindung zwischen dem Piezoelement und der Glaseinschmelzung oder zwischen der Glaseinschmelzung und der Weiterleitung zum Steckerteil ist hier nach der Montage nicht mehr prüfbar auf einen richtigen Kontakt, eine ausreichende Verlötung oder auf die richtige geometrische Position und den Sitz.

### Offenbarung der Erfindung

Die Erfindung geht von einer eingangs beschriebenen Anordnung mit einem Piezoaktor aus, der als Piezoelement einen Mehrschichtaufbau von Piezolagen aufweist, die in einem Haltekörper gehalten sind, wobei am Piezoelement eine wechselseitige Kontaktierung von Innenelektroden mit Kontaktelementen vorhanden ist. Es sind weiterhin Zuführdrähte als elektrische Leitungen durch ein Kopfteil des Haltekörpers zu den Kontaktelementen geführt. Gemäß der Erfindung sind die elektrischen Leitungen über ein Verbindungselement durch das Kopfteil des Haltekörpers zu den Kontaktelementen geführt, wobei das Verbindungselement aus einer elektrisch leitenden Steckerhülse besteht, in die an einer Seite die Enden der elektrischen Leitungen von einem Steckerteil und an der anderen Seite die Enden der Leitungen als Verlängerungen der Kontaktelemente einbringbar sind. In der Steckerhülse sind auf einfache Weise im Montageprozess durch Schrumpfung der Steckerhülse die zu verbindenden Enden mechanisch und elektrisch verbindbar.

Es ist weiterhin vorteilhaft, wenn oberhalb des Verbindungselements in Richtung zum Steckerteil die Leitungen in einer Glaseinschmelzung hochdruckdicht gegenüber Flüssigkeiten eingebettet sind. Besonders vorteilhaft ist es, wenn die Steckerhülse als Schrumpfring zumindest teilweise aus einem Memory-Metall gebildet ist, das kalt aufweitbar ist und durch Wärmeeinwirkung in den Zustand vor dem Aufweiten zurückführbar ist.

Somit kann nach erfolgter Montage durch einmaliges Erhitzen der Memory-Metall-Ringe der Rückgang der Aufweitung zu einem festen und sicheren Schrumpfverband genutzt werden. Die Montage ist dabei auch einfach, da durch die Aufweitung ausreichend Spiel im Verbindungselement ist und die Längstoleranzen der Drähte oder Stifte sind leicht ausgleichbar. Durch den festen Sitz entstehen kaum noch sog. Mikrobewegungen im Steckerbereich und der gesamte Aufbau ist in seiner Länge an kundenspezifische Lösungen anpassbar.

Vorteilhaft und kostengünstig kann es hierbei sein, wenn die Steckerhülse zum Teil aus einem preiswerten und besser leitfähigem nichtschrumpfenden leitenden Material ist und nur ein kurzer Schrumpfring oben oder unten auf dieses Material mit den innenliegenden Stiften als Enden der Leitungen aufgestülpt wird. Zur axialen Fixierung des kurzen Schrumpfrings kann die Steckerhülse eine Verdickung oder Verbördelung aufweisen.

Auch ist es möglich, dass die Steckerhülse zum Teil aus einem nichtschrumpfenden leitenden Materialgebildet ist und ein kurzer Schrumpfring oben oder unten axial aufgelötet oder sonst wie fest verbunden wird. Die jeweils nicht im Bereich des kurzen Schrumpfringes liegenden Stifte können dann mit der Steckerhülse verlötet, verschweißt, verkrimpt oder sonst wie fest verbunden werden. Vorteilhaft für die Montage ist es außerdem, wenn die Steckerhülse hier am einen oder an beiden Enden einen Längsschlitz aufweist

Gemäß einer anderen Ausführungsform kann der kurze Schrumpfring auch auf die überlappenden Enden der Stifte aufgestülpt werden, wobei auch hier der Schrumpfring zunächst kalt verformt wird und dann auf die Stifte aufgebracht wird. Nach einer Erwärmung geht dieser dann wieder in seine alte Form zurück und übt zur Verbindung der beiden Enden auf diese eine Schrumpfkraft aus.

Bei einem vorteilhaften Herstellungsverfahren wird in einem ersten Verfahrensschritt eine Polung und Signalprüfung des Piezoelements sowie eine Prüfung der Hochdruckdichtigkeit durchgeführt und in einem zweiten Verfahrensschritt wird die Verbindung der Leitungen zwischen dem Steckerteil und den Kontaktelementen mit einem Verbindungselement durchgeführt.

### Kurze Beschreibung der Zeichnungen

Ausführungsbeispiele der erfindungsgemäßen Anordnung werden anhand der Zeichnungen erläutert. Es zeigen:
Figur 1 einen Längsschnitt durch einen Piezoinjektor mit einem Piezoaktor in einem prinzipiellen geometrischen Aufbau nach dem Stand der Technik,
Figur 2 einen Teillängsschnitt durch ein erfindungsgemäßes Ausführungsbeispiel eines Piezoaktors mit innenliegender Kontaktierung von Innelektroden eines Piezoelements, bei der nichtdurchgehende elektrische Leitungen von einem äußeren Stecker durch einen Schrumpfring geführt sind,
Figur 3 ein Beispiel mit einem kurzen Schrumpfring am oberen Ende,
Figur 4 ein Beispiel mit einem kurzen Schrumpfring am unteren Ende,
Figur 5 ein Beispiel mit einem fest am oberen Ende einer Steckerhülse angebrachten Schrumpfring,
Figur 6 ein Beispiel mit einer geschlitzten Steckerhülse und
Figur 7a und 7b ein Beispiel mit einem Schrumpfring über überlappende Enden der Leitungen.

### Ausführungsform(en) der Erfindung

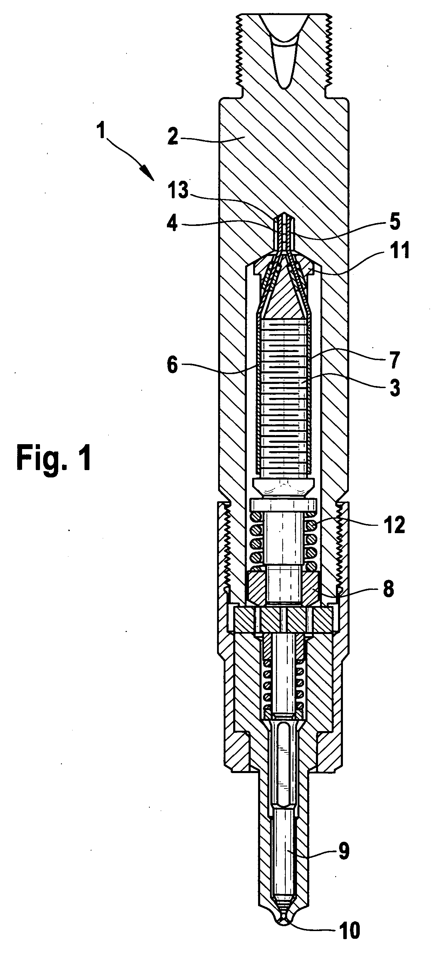

In Figur 1 ist ein prinzipieller Aufbau eines bekannten einstufigen Piezoinjektors 1 mit einem Piezoaktor gezeigt, der aufgrund seiner vorgeschlagenen Anwendung im Folgenden auch als Einspritzinjektor bezeichnet wird und beispielsweise für eine direkte Nadelhubsteuerung im Einspritzsystem für Kraftstoff bei einem Verbrennungsmotor eingesetzt werden kann. Im oberen Teil ist ein Haltekörper 2 vorhanden, der in seinen geometrischen Abmessungen im wesentlichen an den spezifischen Einsatzort angepasst werden kann. Am Haltekörper 2 ist ein hier nicht dargestelltes Steckerteil vorhanden, durch das mit einer ebenfalls spezifisch an den Anwendungsfall angepassten Steckerausführung die elektrische Spannung zur Ansteuerung eines Piezoelements 3 angeschlossen werden kann.

Vom Steckerteil sind hier Zuführdrähte als elektrische Leitungen 4 und 5 zu Außenelektroden 6 und 7 am Piezoelement 3 geführt, das bei einer Betätigung über eine sich hier senkrecht unterhalb befindliche mechanische Anordnung mit einem Koppler 8 auf eine Düsennadel 9 derart wirkt, dass hier eine Freigabe einer Düsenöffnung 10 erfolgen kann. Ein im Inneren des Piezoaktors 1 durch den Innenraum des Haltekörpers 2 geführter Kraftstoff kann somit in den Brennraum eines hier nicht dargestellten Verbrennungsmotors injiziert werden.

Das Piezoelement 3 liegt nach der Figur 1 über einen Aktorfuß 11 oben an einem balligen Dichtsitz im Innenraum des Haltekörpers 2 an, wobei das Piezoelement 3 zur Bewirkung eines guten Dichtsitzes mit einer Feder 12 angedrückt wird. Insbesondere bei den eingangs erwähnten Common-Rail (CR)-Systemen ist hier eine Hochdruckabdichtung zu einem elektrischen Anschlussraum 13 notwendig, durch den die zwei elektrischen Leitungen 4 und 5 an das Piezoelement 3 geführt sind.

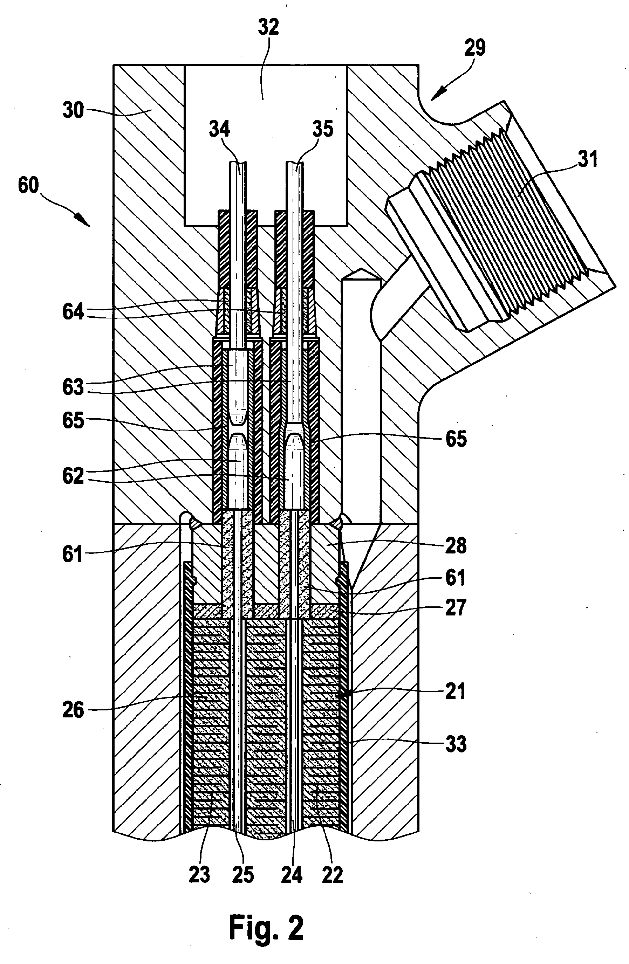

Aus Figur 2 ist ein Teil eines erfindungsgemäßen Piezoaktors 60 im zusammengebauten Zustand zu entnehmen. Es ist hier ein Piezoelement 21 vorhanden, bei dem hier nur beispielhaft Innenelektroden 22 und 23 mit einem Bezugszeichen versehen sind, die im Stapelaufbau des Piezoelements 21 wechselseitig jeweils über innere Kontaktelemente 24 und 25 mit einer elektrischen Spannung versorgt werden. Durch das Potentialgefälle bei Anlage einer Spannung wird die in der Beschreibungseinleitung erläuterte mechanische Reaktion in den Piezolagen 26 aus Keramikfolien zwischen den Innenelektroden 22 und 23 bewirkt.

Das Piezoelement 21 liegt weiterhin über eine Deckplatte 27 aus Keramik und einen Aktorfuß 28 aus Stahl am Haltekörper 29 des Piezoaktors 60 an, wobei der Haltekörper 29 ein Kopfteil 30 aufweist, das zum einen eine Kraftstoffzufuhr 31 und ein elektrisches Anschlussteil 32 aufweist. Das Piezoelement 21 ist gegenüber dem Kraftstoff im Inneren des Haltekörpers 29 noch mit einer äußeren Isolationsschicht 33 abgedichtet.

Im Inneren des Kopfteils 30 sind Zuführdrähte als Leitungen 34 und 35 isoliert eingefügt, die zum Anschluss an das Piezoelement 21 hochdruckdicht vorzugsweise mittels einer Glaseinschmelzung 64 eingepresst sind. Die Zuleitungen für die innenliegenden Kontaktelemente 24 und 25 sind hier über Isolierhülsen 61, vorzugsweise aus Keramik, durch die Aktorfußteile 27, 28 zum Kopfteil 29 des Piezoaktors 60 geführt. Die Isolierhülsen 61 dienen hierbei gleichzeitig der Zentrierung des Piezoelements 21 bzw. der Aktorfußteile 27, 28.

Die Zuleitungen für die innenliegenden Kontaktelemente 24 und 25 enden an Stiften 62, ebenso wie die Zuleitungen vom obenliegenden Steckerteil auch in Stiften 63 (hier mit unterschiedlichen Durchmessern) enden. Die Zuleitungen für die Stifte 63 werden dabei durch eine hochdruckdichte Glaseinschmelzung 64 geführt. Die Stifte 62 und 63 werden hier beidseitig in eine Steckerhülse 65 geführt, die bei dieser Variante als sogenannter Schrumpfring ausgeführt ist. Da die Steckerhülse 65 leitend sein muss, kann sie beispielsweise aus einem Memory-Metall (NiFe-Legierung) hergestellt sein, das vor der Montage ausgeweitet wird und bei Erwärmung in seinen Ausgangszustand zurückschrumpft. Dadurch werden dann die Stifte 62 und 63 fest mit der Steckerhülse 65 verbunden, die jeweils wiederum isoliert im Kopfteil 29 liegt.

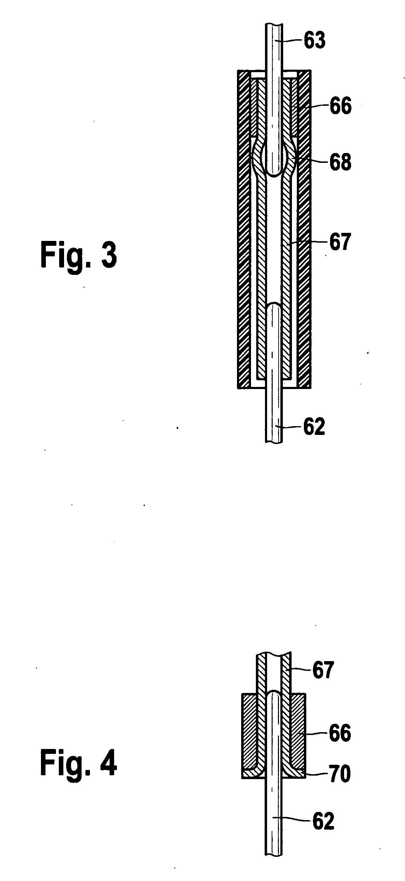

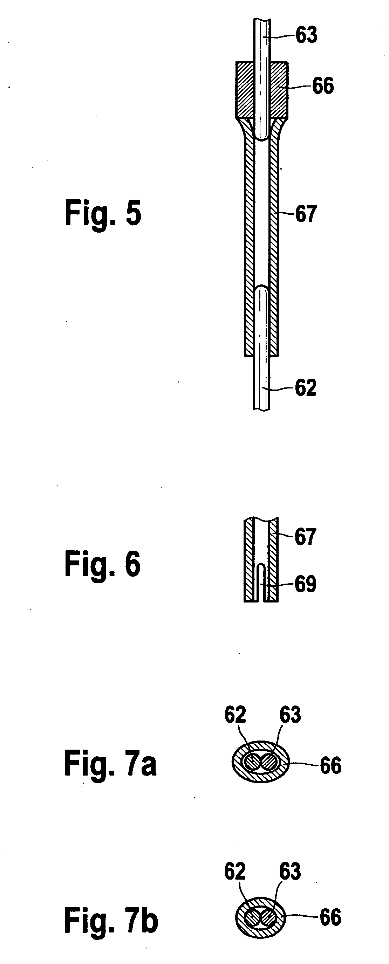

Aus Kostengründen kann auch gemäß Figur 3 nur ein relativ kleiner Schrumpfring 66 verwendet werden, der über eine normale leitende Steckerhülse 67 geführt wird. Die Steckerhülse 67 kann dabei mit einer Aufweitung 68 versehen werden, die zur axialen Positionierung des Schrumpfringes 66 dient. Die Ausführung nach Figur 4 zeigt eine Anbringung des Schrumpfringes 66 am unteren Stift 62 mit einer äußeren Umbördelung 70 der Steckerhülse 67 und aus Figur 5 ist noch zu entnehmen, wie der Ring 66 auf die Steckerhülse 67 oben fest aufgebracht wird, zum Beispiel durch löten.

In allen zuvor beschriebenen Fällen erfolgt das Aufweiten und Erwärmen, wie anhand der Figur 2 beschrieben. Der jeweils andere nicht mit einem Schrumpfring 66 versehene Stift 62 oder 63 kann durch löten, schweißen oder krimpen an der Steckerhülse 67 befestigt werden. Zur besseren Nachgiebigkeit der Steckerhülse 67 bei der Verbindung mit den Stiften 62 oder 63 kann hier noch an den jeweiligen Enden ein Längsschlitz 69 gemäß Figur 6 angebracht werden.

Aus Figur 7a und 7b ist noch zu entnehmen, wie der Schrumpfring 66 auch auf die überlappenden Enden der Stifte 62 und 63 aufgestülpt wird. Auch hier wird der Schrumpfring 66 zunächst kalt verformt und auf die Stifte 62 und 63 aufgebracht (Fig. 7a) und nach einer Erwärmung will der Schrumpfring 66 wieder in seine alte Form zurück und übt dadurch eine verbindende Kraft auf die Stifte 62 und 63 (Fig. 7b) aus.

Obwohl die erfindungsgemäße Zuleitungen bei den beschriebenen Ausführungsbeispielen für innenliegende Kontaktelemente beschrieben sind, ist die dadurch gewonnene flexible Verbindung der Zuleitungen auch für außenliegende Kontaktelemente (vgl. Fig. 1) anwendbar.

### Gewerbliche Anwendbarkeit

Die Erfindung ist zur Steuerung des Hubs einer Nadel für die Kraftstoffeinspritzung in einem Kraftfahrzeug einsetzbar und zwar sowohl mit einer einstufigen als auch mit einer zweistufigen Übersetzung.

## Patentansprüche

1. Anordnung mit einem Piezoaktor, mit
- einem Mehrschichtaufbau von Piezolagen (26), die als Piezoelement (3;21) in einem Haltekörper (2;29,30) gehalten sind, wobei am Piezoelement (3;21) eine innere wechselseitige Kontaktierung von Innenelektroden (22,23) mit Kontaktelementen (24,25) vorhanden ist und mit
- elektrischen Leitungen (34,35), die durch ein Kopfteil (30) des Haltekörpers (29) zu den Kontaktelementen (24,25) geführt sind, **dadurch gekennzeichnet, dass**
- die elektrischen Leitungen über ein Verbindungselement (65;66,67) durch das Kopfteil (30) des Haltekörpers (29) zu den Kontaktelementen (24,25) geführt sind, wobei
- das Verbindungselement aus einer elektrisch teilenden Steckerhülse (65;66,67) besteht, in die an einer Seite die Enden (63) der elektrischen Leitungen von einem Steckerteil und an der anderen Seite die Enden (62) der Leitungen als Verlängerungen der Kontaktelemente (24,25) einbringbar sind und dass
- in der Steckerhülse (65;66,67) im Montageprozess durch Schrumpfung der Steckerhülse (65;66,67) die zu verbindenden Enden mechanisch und elektrisch verbindbar sind.

2. Anordnung nach Anspruch 1, **dadurch gekennzeichnet, dass**
- oberhalb des Verbindungselements in Richtung zum Steckerteil (32) die Leitungen in einer Glaseinschmelzung (64) hochdruckdicht gegenüber Flüssigkeiten eingebettet sind.

3. Anordnung nach Anspruch 1 oder 2, **dadurch gekennzeichnet, dass**
- die Steckerhülse (65;66,67) als Schrumpfring zumindest teilweise aus einem Memory-Metall gebildet ist, das kalt aufweitbar ist und durch Wärmeeinwirkung in den Zustand vor dem Aufweiten zurückführbar ist.

4. Anordnung nach einem der vorhergehenden Ansprüche, **dadurch gekennzeichnet, dass**
- die Steckerhülse (66,67) zum Teil aus einem nichtschrumpfenden leitenden Material (67) ist und ein kurzer Schrumpfring (66) oben oder unten auf das Material (67) mit den innenliegenden Stiften (62,63) als Enden der Leitungen aufstülpbar ist.

5. Anordnung nach Anspruch 4, **dadurch gekennzeichnet, dass**
- zur axialen Fixierung des kurzen Schrumpfrings (66) die Steckerhülse (67) eine Verdickung (68) oder Verbördelung (70) aufweist.

6. Anordnung nach einem der Ansprüche 1 bis 3, **dadurch gekennzeichnet, dass**
- die Steckerhülse (66,67) zum Teil aus einem nichtschrumpfenden leitenden Material (67) gebildet ist und ein kurzer Schrumpfring (66) oben oder unten axial aufgelötet oder sonst wie fest verbunden ist.

7. Anordnung nach einem der Ansprüche 4 bis 6, **dadurch gekennzeichnet, dass**
- die jeweils nicht im Bereich des kurzen Schrumpfringes (66) liegenden Stifte (62,63) als Enden der Leitungen mit der Steckerhülse (67) verlötet, verschweißt, verkrimpt oder sonst wie fest verbunden sind.

8. Anordnung nach einem der Ansprüche 4 bis 7, **dadurch gekennzeichnet, dass**
- die Steckerhülse (67) aus einem nichtschrumpfenden leitenden Material (67) am einen oder an beiden Enden einen Längsschlitz (69) aufweist

9. Anordnung nach einem der Ansprüche 4 bis 8, **dadurch gekennzeichnet, dass**
- der kurze Schrumpfring (66) auf die überlappenden Enden der Stifte (62, 63) aufstülpbar ist, wobei der Schrumpfring (66) zunächst kalt verformt und auf die Stifte (62,63) aufgebracht ist und nach einer Erwärmung in seine alte Form zurückgeht.

10. Verfahren zur Herstellung einer Anordnung mit einem Piezoaktor nach einem der vorhergehenden Ansprüche , **dadurch gekennzeichnet, dass**
- in einem ersten Verfahrensschritt eine Polung und Signalprüfung des Piezoelements (21) sowie eine Prüfung der Hochdruckdichtigkeit durchgeführt wird und
- in einem zweiten Verfahrensschritt die Verbindung der Leitungen (24,25;62,63) zwischen dem Steckerteil und den Kontaktelementen (34,35) im Verbindungselement (65;66,67) durchgeführt wird.

## Claims

1. Arrangement comprising a piezoactuator, with
- a multilayer structure of piezo layers (26), which are held as a piezo element (3; 21) in a holding body (2; 29, 30), inner alternating contacting of inner electrodes (22, 23) with contact elements (24, 25) taking place on the piezo element (3; 21), and with
- electric lines (34, 35), which are led through a head part (30) of the holding body (29) to the contact elements (24, 25), **characterized in that**
- the electric lines are led through the head part (30) of the holding body (29) to the contact elements (24, 25) by way of a connecting element (65; 66, 67),
- the connecting element comprising an electrically conductive connector sleeve (65; 66, 67), into which the ends (63) of the electric lines of a connector part can be inserted on one side and on the other side the ends (62) of the lines can be inserted as extensions of the contact elements (24, 25), and **in that**
- the ends to be connected can be mechanically and electrically connected in the connector sleeve (65; 66, 67) in the assembly process by shrinking the connector sleeve (65; 66, 67).

2. Arrangement according to Claim 1, **characterized in that**
- above the connecting element in the direction of the connector part (32), the lines are embedded in a fused glass seal (64) with impermeability to liquids under high pressure.

3. Arrangement according to Claim 1 or 2, **characterized in that**
- the connector sleeve (65; 66, 67) is formed as a shrink ring, at least partially from a memory metal, which can be made to expand when cold and, by the effect of heat, can be returned to the state before expanding.

4. Arrangement according to one of the preceding claims, **characterized in that**
- the connector sleeve (66, 67) is partly made of a non-shrinking conductive material (67) and a short shrink ring (66) can be slipped over the material (67) from above or below, with the pins (62, 63) that are lying on the inside acting as the ends of the lines.

5. Arrangement according to Claim 4, **characterized in that**
- the connector sleeve (67) has a thickening (68) or flanging (70) for the axial fixing of the short shrink ring (66).

6. Arrangement according to one of Claims 1 to 3, **characterized in that**
- the connector sleeve (66, 67) is formed at least partly from a non-shrinking conductive material (67) and a short shrink ring (66) is soldered on, or firmly connected in some other way, from above or below.

7. Arrangement according to one of Claims 4 to 6, **characterized in that**
- the pins (62, 63) that are respectively not in the region of the short shrink ring (66) are soldered, welded, crimped or firmly connected in some other way to the connector sleeve (67) as ends of the lines.

8. Arrangement according to one of Claims 4 to 7, **characterized in that**
- the connector sleeve (67) of a non-shrinking conductive material (67) has a longitudinal slit (69) at one or both ends.

9. Arrangement according to one of Claims 4 to 8, **characterized in that**
- the short shrink ring (66) can be slipped over the overlapping ends of the pins (62, 63), the shrink ring (66) first being cold-formed and fitted onto the pins (62, 63) and returning to its old form after heating.

10. Method for producing an arrangement with a piezoactuator according to one of the preceding claims, **characterized in that**
- in a first method step, a polarization and signal testing of the piezo element (21) and testing of the high-pressure impermeability is carried out and
- in a second method step, the connection of the lines (24, 25; 62, 63) between the connector part and the contact elements (34, 35) is carried out in the connecting element (65; 66, 67).

## Revendications

1. Ensemble comportant un actionneur piézoélectrique, avec :
- une structure multicouche de couches piézoélectriques (26) qui sont maintenues sous forme d'élément piézoélectrique (3 ; 21) dans un corps de retenue (2 ; 29, 30), l'élément piézoélectrique (3; 21) offrant une mise en contact interne alternative d'électrodes internes (22, 23) avec des éléments de contact (24, 25), et avec
- des ligne électriques (34, 35) qui sont guidées à travers une partie de tête (30) du corps de retenue (29) jusqu'aux éléments de contact (24, 25), **caractérisé en ce que**
- les lignes électriques sont guidées par le biais d'un élément de connexion (65 ; 66, 67) à travers la partie de tête (30) du corps de retenue (29) jusqu'aux éléments de contact (24, 25),
- l'élément de connexion se composant d'un manchon de connecteur électriquement conducteur (65 ; 66, 67) dans lequel d'un côté les extrémités (63) des lignes électriques peuvent être montées par une partie d'enfichage et de l'autre côté les extrémités (62) des lignes peuvent être montées sous forme de prolongements des éléments de contact (24, 25) et **en ce que**
- dans le manchon de connecteur (65, 66, 67) pendant le processus de montage par frettage du manchon de connecteur (65 ; 66, 67), les extrémités à connecter peuvent être connectées mécaniquement ou électriquement.

2. Ensemble selon la revendication 1, **caractérisé en ce que**
au-dessus de l'élément de connexion dans la direction de la partie d'enfichage (32), les lignes sont noyées dans une fusion de verre (64) de manière étanche aux pressions élevées vis-à-vis des liquides.

3. Ensemble selon la revendication 1 ou 2,
**caractérisé en ce que**
le manchon de connecteur (65 ; 66, 67) est formé sous forme de bague de serrage au moins en partie en un métal à mémoire qui peut être élargi à froid et qui peut être ramené dans l'état préalable à l'écartement par application de chaleur.

4. Ensemble selon l'une quelconque des revendications précédentes, **caractérisé en ce que**
le manchon de connecteur (66, 67) est en partie constitué d'un matériau conducteur (67) non rétractable, et une bague de serrage courte (66) peut être enfoncée par le haut ou par le bas sur le matériau (67) avec les broches internes (62, 63) en tant qu'extrémités des lignes.

5. Ensemble selon la revendication 4, **caractérisé en ce que**
- pour la fixation axiale de la bague de serrage (66), le manchon de connecteur (67) présente un épaississement (68) ou une bordure (70).

6. Ensemble selon l'une quelconque des revendications 1 à 3, **caractérisé en ce que**
le manchon de connecteur (66, 67) est formé en partie d'un matériau non rétractable, et une bague de serrage courte (66) est brasée axialement en haut ou en bas ou est autrement connectée fixement.

7. Ensemble selon l'une quelconque des revendications 4 à 6, **caractérisé en ce que**
les broches (62, 63) non situées dans la région de la bague de serrage courte (66) sont brasées, soudées ou serties ou bien autrement connectées fixement en tant qu'extrémités des lignes au manchon de connecteur (67).

8. Ensemble selon l'une quelconque des revendications 4 à 7, **caractérisé en ce que**
le manchon de connecteur (67) en matériau conducteur non rétractable (67) présente une fente longitudinale (69) sur une ou les deux extrémités.

9. Ensemble selon l'une quelconque des revendications 4 à 8, **caractérisé en ce que**
la bague de serrage courte (66) peut être enfoncée sur les extrémités se chevauchant des broches (62, 63), la bague de serrage (66) étant d'abord déformée à froid puis étant montée sur les broches (62, 63) et revenant à sa forme ancienne après chauffage.

10. Procédé de fabrication d'un ensemble comportant un actionneur piézoélectrique selon l'une quelconque des revendications précédentes, **caractérisé en ce que**
- dans une première étape du procédé, on effectue une polarisation et une vérification du signal de l'élément piézoélectrique (21) ainsi qu'une vérification de l'étanchéité à haute pression et
- dans une deuxième étape du procédé, on effectue la connexion des lignes (24, 25 ; 62, 63) entre la partie d'enfichage et les éléments de contact (34, 35) dans l'élément de connexion (65 ; 66, 67).
